# EUROPEAN PATENT APPLICATION

(11) **EP 4 704 312 A1**
(43) Date of publication of application: **04.03.2026**
(21) Application number: 25152796.6
(22) Date of filing: 20.01.2025
(51) Int. Cl.: H02K 3/04, H02K 3/47, H02K 11/215, H02K 3/26, H05K 1/16

(54) **MOTOR STATOR AND ALTERNATING CURRENT MOTOR**

(30) Priority: 29.08.2024 CN 202411196431
(71) Applicant: Fortior Technology (Shanghai) Co., Ltd., Shanghai 201800 (CN)
(72) Inventor: BI, Chao, Shanghai, 201800 (CN); MA, Xiaojun, Shanghai, 201800 (CN); BI, Lei, Shanghai, 201800 (CN)
(74) Representative: Monteiro Alves, Inês

(57) **Abstract**

Disclosed are a motor stator and an AC motor. The motor stator includes a stator yoke and a stator winding. A cavity is provided inside the stator yoke. The stator winding includes a flexible circuit board formed by winding and having a same shape as the cavity. The flexible circuit board includes a plurality of groups of coils, the plurality of groups of coils are provided at intervals along a circumference of the stator yoke and are electrically connected to the terminal. The flexible circuit board is attached to an inner wall of the stator yoke. Current passes through the coil, generating a radial magnetic field perpendicular to the stator yoke in an air gap of the motor, and interacts with a rotor magnetic field to generate an electromagnetic torque required for an operation of the motor.

## Description

### TECHNICAL FIELD

The present application relates to the technical field of motors, and in particular to a motor stator and an alternating current (AC) motor.

### BACKGROUND

With the continuous advancement of science and technology, high-performance motors play an increasingly important role in many fields such as robots and medical equipment. Three-phase AC motors, especially three-phase permanent magnet AC motors, are widely used in robots, medical equipment and other fields due to their high torque density and good reliability. This type of motor generates a driving torque by the interaction between the magnetic field generated by the current in the stator winding and the magnetic field generated by the permanent magnetic material on the rotor.

However, the structure of this motor stator is relatively complex, including a stator core and an armature winding. The stator core is provided with stator slots. The armature winding is provided according to the structure of the stator core and embedded in the stator core. This structure is easy to implement in large-size motors, but in small motors, due to the presence of stator slots and armature windings, the structure of the motor stator is difficult to process and assemble.

### SUMMARY

The main purpose of the present application is to provide a motor stator and an AC motor, aiming to solve the problem that the existing motor stator is difficult to process and assemble in a small motor.

To achieve the above purpose, the present application provides a motor stator, including: a stator yoke and a stator winding. A cavity with two ends passing through is provided inside the stator yoke. The stator winding includes a flexible circuit board formed by winding and having a same shape as the cavity. One end of the flexible circuit board is provided with a terminal, the terminal is configured to connect an external alternating current (AC) power source. The flexible circuit board includes at least two conductive layers, and a plurality of groups of coils are provided in the conductive layers. The plurality of groups of coils are provided at intervals along a circumference of the stator yoke, and are electrically connected to the terminal. The flexible circuit board is attached to an inner wall of the stator yoke. The current passes through the coil, generating a radial magnetic field perpendicular to the stator yoke in an air gap of the motor, and interacts with a rotor magnetic field to generate an electromagnetic torque required for an operation of the motor.

In an embodiment, the at least two conductive layers are provided along a radial direction of the stator yoke sequentially, and a quantity of coils in the at least two conductive layers is the same.

In an embodiment, the at least two conductive layers are provided with a conductive perforation in a middle of each coil. The conductive perforations of the at least two conductive layers are overlapped, and the conductive perforations are configured for establishing electrical connections between the coils of the at least two conductive layers.

In an embodiment, three coils are provided in each conductive layer, and the flexible circuit board is wound along the circumference of the stator yoke to form a three-phase stator winding with an electrical angle width of 120 degrees.

In an embodiment, the flexible circuit board includes a first-section flexible circuit board and a second-section flexible circuit board, and a quantity of coils provided in the first-section flexible circuit board and the second-section flexible circuit board is the same. The second-section flexible circuit board is connected to one side of the first-section flexible circuit board and folded toward the first-section flexible circuit board, enabling the second-section flexible circuit board is provided above the first-section flexible circuit board and partially overlapped with the first-section flexible circuit board. The first-section flexible circuit board and the second-section flexible circuit board are wound to form two turns of stator windings provided along the radial direction of the stator yoke sequentially.

In an embodiment, three coils are provided in a conductive layer of the first-section flexible circuit board and a conductive layer of the second-section flexible circuit board. An electrical angle width of the three coils in the conductive layer of the first-section flexible circuit board and the conductive layer of the second-section flexible circuit board is 120 degrees, and an electrical angle of two sections of the stator windings differs by 120 degrees or 240 degrees.

In an embodiment, the flexible circuit board includes a first-section flexible circuit board, a second-section flexible circuit board and a third section flexible circuit board, and the first-section flexible circuit board and the third-section flexible circuit board are respectively connected to a same side or opposite sides of the second-section flexible circuit board. The first-section flexible circuit board, the second-section flexible circuit board and the third-section flexible circuit board are provided with a same quantity of coils. The second-section flexible circuit board is folded toward the first-section flexible circuit board to partially overlap the first-section flexible circuit board, and the third-section flexible circuit board is folded toward the second-section flexible circuit board to partially overlap the second-section flexible circuit board. The first-section flexible circuit board, the second-section flexible circuit board and the third-section flexible circuit board are wound to form three turns of stator winding provided along the radial direction of the stator yoke sequentially.

In an embodiment, two coils are provided in a conductive layer of the first-section flexible circuit board, the second-section flexible circuit board and the third-section flexible circuit board; an electrical angle width of the two coils of each section of the conductive layer is 180 degrees, and electrical angles of three sections of the stator winding differ by 120 degrees or 240 degrees.

In an embodiment, the motor stator further includes a magnetic field detection component. The magnetic field detection component includes a circuit control board and a Hall sensor; the Hall sensor is provided on the circuit control board, and the circuit control board is connected to a side of the flexible circuit board provided with the terminal. The flexible circuit board is wound to form the stator winding, and the stator winding is cylindrical; the circuit control board is in a shape of a ring. After the flexible circuit board is wound to form the stator winding, the circuit control board is provided at an opening of the stator winding in a cover-like manner; an outer periphery of the circuit control board is provided with a positioning groove, and the opening of the stator winding is provided with a positioning tooth. The positioning tooth is clamped in the positioning groove. And the Hall sensor is configured to detect a magnetic field of a rotor when the motor is running, and then detect an angle of the rotor.

In an embodiment, the present application also provides an AC motor, including: a front ring, a rear ring, a rotor, a bearing and the motor stator described in any of the above embodiments.

The present application sets a coil on a flexible circuit board, and makes the flexible circuit board attached to the inner wall of the stator yoke. Compared with the solution of setting the coil in the stator slot of the stator core, the structural volume occupied by the stator winding can be reduced. At the same time, since the present application does not need to set the stator slot on the stator yoke, the stator winding can be installed only by attachment, thereby improving the convenience of processing and assembly the motor stator.

### BRIEF DESCRIPTION OF THE DRAWINGS

In order to more clearly illustrate the embodiments of the present application or the technical solutions in the related art, the drawings required for use in the embodiments or the description of the related art will be briefly introduced below. Obviously, the drawings described below are only some embodiments of the present application. For those skilled in the art other drawings can be obtained based on the structures shown in these drawings without creative work.
FIG. 1 is a schematic structural view of an AC motor according to an embodiment of the present application.
FIG. 2 is a partially enlarged view along a section A-A of FIG. 1.
FIG. 3 is a schematic structural view of a stator yoke in a motor stator according to an embodiment of the present application.
FIG. 4 is a schematic structural view of an unfolded flexible circuit board according to an embodiment of the present application.
FIG. 5 is a schematic structural view of the flexible circuit board in FIG. 4 being overlapped.
FIG. 6 is a schematic structural view of the flexible circuit board in FIG. 4 being wound to form a stator winding.
FIG. 7 is a schematic structural view of an unfolded flexible circuit board according to another embodiment of the present application.
FIG. 8 is a schematic structural view of the flexible circuit board in FIG. 7 being overlapped.
FIG. 9 is a schematic structural view of the flexible circuit board in FIG. 8 being wound to form a stator winding.
FIG. 10 is a schematic structural view of an unfolded flexible circuit board according to yet another embodiment of the present application.
FIG. 11 is a schematic structural view of the flexible circuit board in FIG. 10 being overlapped.
FIG. 12 is a schematic structural view of the flexible circuit board in FIG. 11 being wound to form a stator winding.
FIG. 13 is a schematic structural view of an unfolded flexible circuit board according to still another embodiment of the present application.

Description of reference signs: 10. stator yoke; 11. annular silicon steel sheet; 12. cavity; 20. stator winding; 21. flexible circuit board; 211. first-section flexible circuit board; 212. second-section flexible circuit board; 213. third-section flexible circuit board; 214. coil; 215. conductive perforation; 22. terminal; 23. conductive layer; 24. positioning tooth; 30. magnetic field detection component; 31. circuit control board; 32. hall sensor; 33. positioning groove; 40. rotor; 50. front ring; 60. rear ring; 70. bearing.

The realization of the objective, functional characteristics, and advantages of the present application are further described with reference to the accompanying drawings.

### DETAILED DESCRIPTION OF THE EMBODIMENTS

The technical solutions of the embodiments of the present application will be described in more detail below with reference to the accompanying drawings. It is obvious that the embodiments to be described are only some rather than all of the embodiments of the present application. All other embodiments obtained by those skilled in the art based on the embodiments of the present application without creative efforts shall fall within the scope of the present application.

It should be noted that if there is a directional indication (such as up, down, left, right, front, rear) in the embodiments of the present application, the directional indication is only configured to explain the relative positional relationship, movement, etc. of the components in a certain posture (as shown in the drawings). If the specific posture changes, the directional indication will change accordingly.

Besides, the descriptions associated with, e.g., "first" and "second" in the present application are merely for descriptive purposes, and cannot be understood as indicating or suggesting relative importance or impliedly indicating the number of the indicated technical feature. Therefore, the feature associated with "first" or "second" can expressly or impliedly include at least one such feature. The meaning of "and/or" appearing in the present application includes three parallel scenarios. For example, "A and/or B" includes only A, or only B, or both A and B. In addition, the technical solutions between the various embodiments can be combined with each other, but they must be based on the realization of those skilled in the art. When the combination of technical solutions is contradictory or cannot be achieved, it should be considered that such a combination of technical solutions does not exist, nor is it within the scope of the present application.

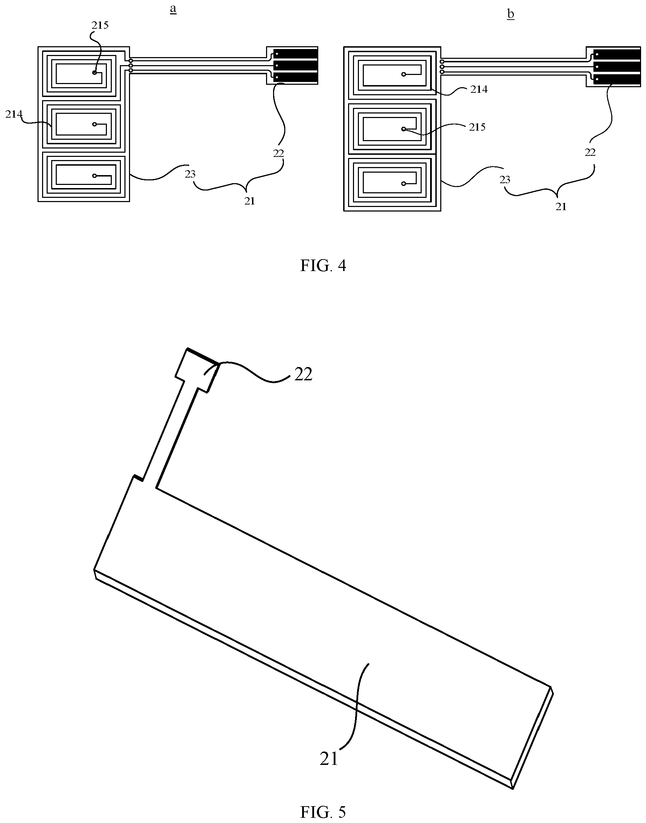

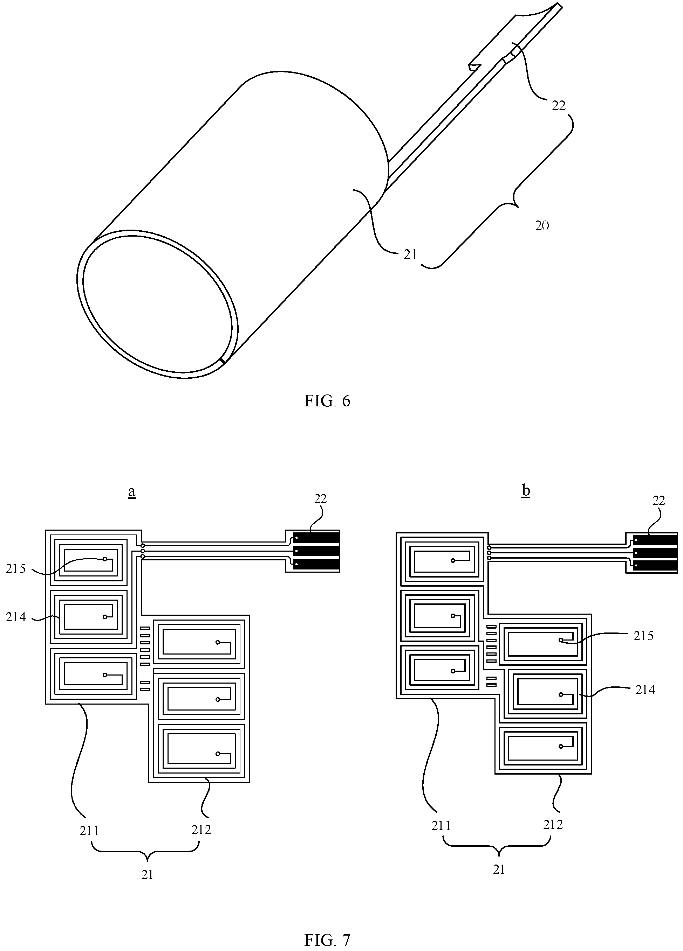

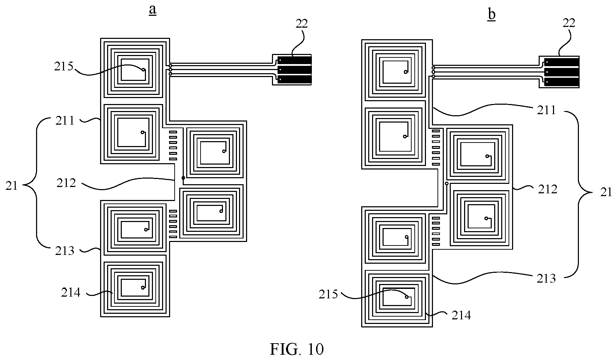

It should be noted that, in FIG. 4, "a" represents the first conductive layer in the flexible circuit board, and "b" represents the second conductive layer in the flexible circuit board. In FIG. 7, "a" represents the first conductive layer in the flexible circuit board, and "b" represents the second conductive layer in the flexible circuit board. In FIG. 10, "a" represents the first conductive layer in the flexible circuit board, and "b" represents the second conductive layer in the flexible circuit board.

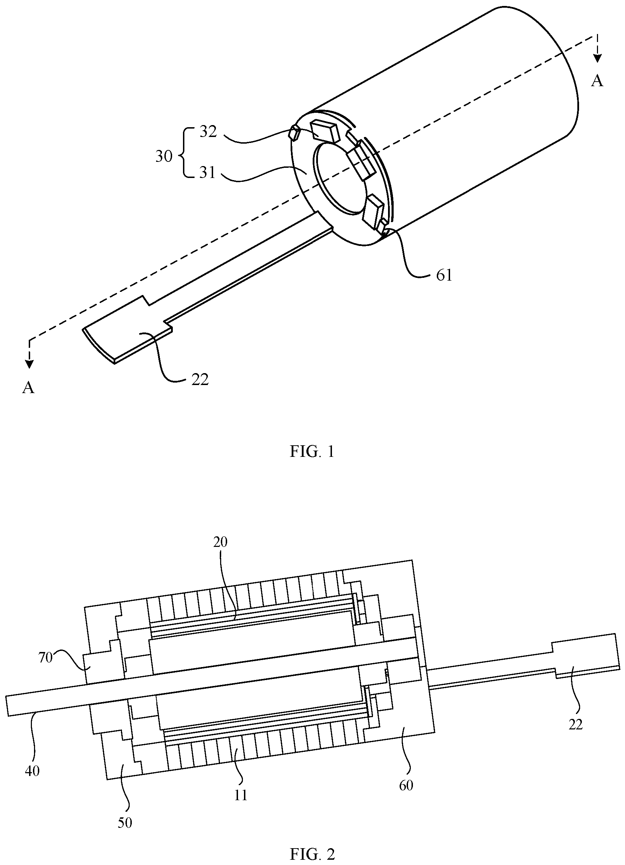

The present application provides a motor stator, as shown in FIG. 1 to FIG. 3, in an embodiment, the motor stator includes a stator yoke 10 and a stator winding 20. A cavity 12 with two ends passing through is provided inside the stator yoke 10. The stator winding 20 includes a flexible circuit board 21 formed by winding and having the same shape as the cavity 12. One end of the flexible circuit board 21 is provided with a terminal 22, and the terminal 22 is configured to connect an external alternating current (AC) power source. The flexible circuit board 21 includes at least two conductive layers 23, and a plurality of groups of coils 214 are provided in the conductive layer 23; the plurality of groups of coils 214 are provided at intervals along the circumference of the stator yoke 10, and are electrically connected to the terminal 22. The flexible circuit board 21 is attached to the inner wall of the stator yoke 10. The current is configured to pass through the coil 214, and a radial magnetic field perpendicular to the stator yoke 10 is generated in the air gap of the motor, and the radial magnetic field nteracts with the stator yoke 10 to form a magnetic field loop yoke 10.

In the embodiment, the stator yoke 10 is stacked by annular silicon steel sheets 11, or other soft magnetic materials with high magnetic conductivity. By using materials with high magnetic permeability, the strength and efficiency of the motor's magnetic field can be improved. When the stator yoke 10 is made of materials such as annular silicon steel sheets 11, the annular silicon steel sheets 11 can be fixed together by bonding, external welding, or bonding and welding to form a hollow cylindrical stator yoke 10. Of course, it can also be a hollow polygonal column or other geometric shapes suitable for motor design.

At the same time, the stator yoke 10 formed by the above-mentioned annular silicon steel sheet 11 and the above-mentioned various fixing methods has a mechanical strength that can meet the application occasions of most small motors. Of course, the stator yoke 10 can also be fixed in a metal shell to enhance the mechanical strength of the stator yoke 10.

An insulating layer made of polyimide or other high-temperature resistant and insulating materials is provided between the at least two conductive layers 23 of the flexible circuit board 21 to prevent the at least two conductive layers 23 from short-circuiting. The coil 214 can be made of copper wire or other materials with good conductivity to reduce resistance loss and improve the efficiency of the motor. The coil 214 is provided in the conductive layer 23, and the conductive layer 23 has a protective effect on the coil 214. The insulating layer between the at least two conductive layers 23 makes the plurality of groups of coils 214 electrically isolated, and also makes the coils 214 and the stator yoke 10 electrically isolated. The manufacturing process of the flexible circuit board 21 can adopt the existing FPCB (Flexible Printed Circuit Board) production process, and the high-precision manufacturing of the coil 214 can be achieved through precise photolithography, etching and deposition technology.

A terminal 22 is provided at one end of the flexible circuit board 21, and the terminal 22 is configured to connect an external AC power source. The plurality of groups of coils 214 provided in the conductive layer 23 are provided at intervals along the circumference of the stator yoke 10, and are electrically connected to the terminal 22. The plurality of groups of coils 214 can be clockwise or counterclockwise, and configured to form a stator winding 20. When an alternating current is passed through the coil 214, a radial magnetic field perpendicular to the stator yoke 10 is generated in the air gap of the motor. When the motor is working, the external AC power source passes current into the stator winding 20 through the terminal 22 of the flexible circuit board 21. Since the plurality of groups of coils 214 are symmetrically distributed, the three-phase time-domain symmetrical current will form a rotating magnetic field in the air gap of the motor. The rotating magnetic field can interact with the magnetic field of the rotor 40, then driving the motor to rotate.

The flexible circuit board 21 is rectangular in shape before winding, and one end of the flexible circuit board 21 is wound around the other end of the flexible circuit board 21 to form a cylindrical shape. The wound flexible circuit board 21 is attached to the inner wall of the stator yoke 10 by gluing to form the stator winding 20. Compared with the solution of setting the coil 214 in the stator slot of the stator core, the structural volume occupied by the stator winding 20 can be reduced. At the same time, since the present application does not need to set the stator slot on the stator yoke 10, the stator winding 20 can be installed only by attachment thereby improving the convenience of processing and assembly the motor stator.

As shown in FIG. 4, FIG. 7 and FIG. 10, in an embodiment, the flexible circuit board 21 includes two conductive layers 23, the at least two conductive layers 23 is provided along the radial direction of the stator yoke 10 sequentially. The plurality of groups of coils 214 are provided in each conductive layer 23, and the quantity of coils 214 in the at least two conductive layers 23 is the same. The coils 214 in each conductive layer 23 are stacked in pairs along the radial direction of the stator yoke 10, and the magnetic field directions of two coils 214 stacked on each other in each conductive layer 23 are the same.

In the embodiment, the flexible circuit board 21 is designed as two conductive layers 23, and the at least two conductive layers 23 are provided in a stacked manner. The at least two conductive layers 23 have the same shape and size, and the quantity and position of the coils 214 in each conductive layer 23 are the same. When the flexible circuit board 21 is unfolded, the at least two conductive layers 23 are provided in a stacked manner with one on top of the other. At the same time, the coils 214 in the at least two conductive layers 23 are also provided in a stacked manner with one on top of the other. The winding directions of the two coils 214 stacked on each other in the at least two conductive layers 23 may be the same or different, but the magnetic field directions of the two coils 214 stacked on each other are the same, so that the magnetic field strength can be improved compared to the solution of the single-layer coil 214. Therefore, according to the winding direction setting of the coil 214 of the at least two conductive layers 23 and the circuit design of the coil 214 and the terminal 22, the present application provides the following two implementations:

### First embodiment

As shown in FIG. 4, FIG. 7 and FIG. 10, the at least two conductive layers 23 are provided with a conductive perforation 215 in the middle of each coil 214. The inner wall of the conductive perforation 215 is plated with a conductive material. The conductive perforations 215 of the at least two conductive layers 23 overlap, and the conductive perforations 215 are configured for establishing electrical connections between the coils 214 of the at least two conductive layers 23. One end of the coil 214 in one conductive layer 23 is electrically connected to the coil 214 in the other conductive layer 23 through the inner wall of the conductive perforation 215. The winding directions of the two mutually stacked coils 214 are opposite. The current is passed through the coil 214 of one conductive layer 23, and then sequentially through the conductive perforation 215 in this conductive layer 23 and the conductive perforation 215 in another conductive layer 23 before flowing to the coil 214 which is stacked with the former in the other conductive layer 23.

A conductive perforation 215 is opened in the middle of each coil 214 in each conductive layer 23, and the inner wall of the conductive perforation 215 is plated with a conductive material, such as copper or silver, to improve the conductivity of the electrical connection. One end of the coil 214 is electrically connected to the inner wall of the conductive perforation 215, and the other end is configured to rotate clockwise or counterclockwise to form a coil 214 and connect another coil 214 or the terminal 22. The design of the conductive perforation 215 not only realizes the electrical connection of the coil 214 in the at least two conductive layers 23, but also allows the coils 214 to be positioned according the position of the conductive perforation 215 during the processing of the flexible circuit board 21, so as to ensure that the coils 214 stacked with each other in the at least two conductive layers 23 are aligned, thereby ensuring the strengthening and uniform distribution of the motor magnetic field.

Here, in order to facilitate the explanation of the flow path of the current, we define the at least two conductive layers 23 as the first conductive layer and the second conductive layer. The coil 214 of the first conductive layer is directly connected to the terminal 22 through a wire. When the terminal 22 is connected to an AC power source, the current flows from the terminal 22 to one of the coils 214 of the first conductive layer. Then, the current flows the overlapping coils 214 of the second conductive layer through the inner wall of the conductive perforation 215, and the coil 214 is connected to another coil 214 at one end relative to the conductive perforation 215, so the current flows another coil 214 of the same conductive layer 23 from the coil 214 of the second conductive layer, and the current is conducted between the two coils 214 of the second conductive layer. Then, the current flows the overlapping coils 214 of the first conductive layer through the conductive perforation 215 of the other coil 214 of the second conductive layer. By analogy, the current flows between the plurality of groups of coils 214 in the at least two conductive layers 23. In this embodiment, the two overlapping coils 214 of the at least two conductive layers 23 have different winding directions, so when the current flows between the two overlapping coils 214 through the conductive perforation 215, the current flow direction can be guaranteed to be the same, so that the two coils 214 generate mutually reinforcing magnetic fields.

### Second embodiment

The coils 214 of the at least two conductive layers 23 are directly electrically connected to the terminal 22 through the wire. When the terminal 22 is connected to the AC power source, the current flows from the terminal 22 to the plurality of groups of coils 214 of the at least two conductive layers 23, and the two coils 214 stacked with each other in the at least two conductive layers 23 are electrically isolated. At the same time, the two overlapping coils 214 have the same winding direction, so when the current passes through the two overlapping coils 214, a mutually reinforcing magnetic field can be generated.

It can be understood that the present application is not limited to the technical solution of only setting two conductive layers 23. In another embodiment, the flexible circuit board 21 can also include four, six or more even-numbered conductive layers 23. Each conductive layer 23 is provided with the same or close number of coils 214, and the positions of the coils overlap each other. The magnetic fields of the overlapping multiple coils 214 have a mutually reinforcing effect. Therefore, the technical solutions of double conductive layers 23, multiple conductive layers 23 and multiple coils 214 all belong to the protection scope of the present application.

As shown in FIG. 4 to FIG. 6, in an embodiment, three coils 214 are provided in the conductive layer 23, and the flexible circuit board 21 is wound along the circumference of the stator yoke 10 to form a three-phase stator winding 20 with an electrical angle width of 120 degrees.

In this embodiment, a basic structure of a "non-folding" Y-type connected stator winding 20 formed by two turns of flexible circuit boards 21 is shown. The stator winding 20 is an asymmetric concentrated winding with an electrical angle width of 120°. The winding of each phase is input with current from the terminal 22 of the winding in the first layer. After the first conductive layer 23 of the flexible circuit board 21 has been wound to form a winding with an electrical angle width of 120° from the outside to the inside, it is electrically connected to the winding of the coil 214 of the second conductive layer 23 through the conductive perforation 215. The second conductive layer 23 is wound from the inside to the outside to form a winding with a width of 120°.

When the terminal 22 is energized, the magnetic field generated by the coil 214 on the first conductive layer 23 of each phase winding and the magnetic field generated by the coil 214 on the second conductive layer 23 are mutually enhanced. The end points of the three-phase windings finally converge to form a Y-type connected three-phase winding.

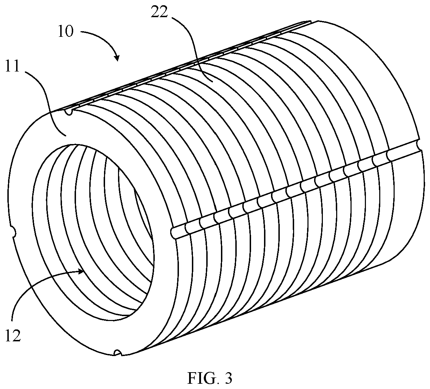

After the above-mentioned flexible circuit board 21 is rolled in the manner shown in FIG. 5 and FIG. 6, a cylindrical flexible circuit board 21 is formed, and its outer diameter is the same as the inner diameter of the stator yoke 10 (see FIG. 3). The cylindrical stator winding 20 is then fixed to the inner side of the stator yoke 10 by gluing. The terminal 22 of the flexible circuit board 21 is extended to the outside of the stator yoke 10 to facilitate the connection of the AC power source. In an embodiment, according to user needs, the quantity of the coils 214 in the conductive layer 23 can be two, four or other quantities of coils 214.

As shown in FIG. 7 to FIG. 9, in an embodiment, the flexible circuit board 21 includes a first-section flexible circuit board 211 and a second-section flexible circuit board 212. The quantity of coils 214 provided in the first-section flexible circuit board 211 and the second-section flexible circuit board 212 is the same. The second-section flexible circuit board 212 is connected to one side of the first-section flexible circuit board 211 and folded toward the first-section flexible circuit board 211, so that the second-section flexible circuit board 212 is provided above the first-section flexible circuit board 211 and partially overlaps with the first-section flexible circuit board 211. The first-section flexible circuit board 211 and the second-section flexible circuit board 212 are wound to form two turns of stator windings 20 provided in sequence along the radial direction of the stator yoke 10.

In an embodiment, three coils 214 are provided in the conductive layer 23 of the first-section flexible circuit board 211 and the conductive layer of the second-section flexible circuit board 212. The electrical angle width of the three coils 214 in the conductive layer 23 of the first-section flexible circuit board 211 is 120 degrees. The electrical angle width of the three coils in the conductive layer of the second-section flexible circuit board 212 is 120 degrees. And the electrical angles of the two turns of stator windings 20 differs by 120 degrees or 240 degrees.

A schematic view of the unfolded state of the stator winding 20 formed by two turns of FPCB in a "single folding type" is shown in FIG. 7. The winding is three-phase and is a symmetrical concentrated winding with an electrical angle width of 120°. The flexible circuit board 21 includes a first-section flexible circuit board 211 and a second-section flexible circuit board 212. The electrical angle width between the first-section flexible circuit board 211 and the second-section flexible circuit board 212 differs by 120° or 240° in the tangential direction. At the same time, the coils 214 of the first-section flexible circuit board 211 and the second-section flexible circuit board 212 are electrically connected.

The coil 214 in the first conductive layer 23 of the first-section flexible circuit board 211 of each phase of the winding is input with current from the terminal 22. After a winding with an electrical angle width of 120° wound from the outside to the inside is formed on the flexible circuit board 21, it is electrically connected to the coil 214 in the second conductive layer 23 of the first-section flexible circuit board 211 through the conductive perforation 215. The second conductive layer 23 provided in the first-section flexible circuit board 211 is wound from the inside to the outside to form a winding with an electrical angle width of 120°. Then the current flows into the coil 214 in the second-section flexible circuit board 212 of the second conductive layer 23 through a lead wire. After a winding with a width of 120° wound from the outside to the inside is formed on the second conductive layer 23 of the second-section flexible circuit board 212, the coil 214 is electrically connected to the coil 214 of the first conductive layer 23 of the second-section flexible circuit board 212 through a conductive perforation 215. Then the current flows into the coil 214 in the first conductive layer 23 of the first-section flexible circuit board 211 through a lead wire.

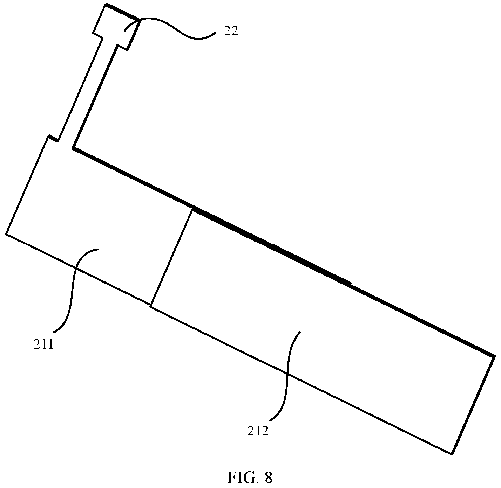

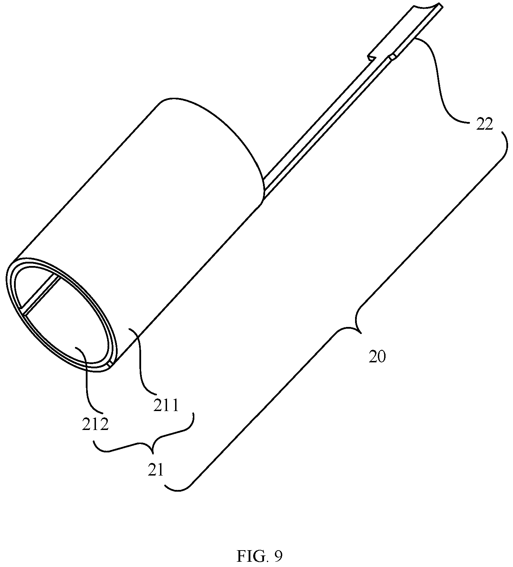

The above-mentioned flexible circuit board 21 is rolled in the manner shown in FIG. 8 and FIG. 9 to form a cylindrical stator winding 20. The outer diameter of the stator winding 20 is the same as the inner diameter of the stator yoke 10. In this way, the cylindrical stator winding 20 can be fixed to the inner side of the stator yoke 10 by gluing. The terminal 22 of the flexible circuit board 21 is extended outward from the stator yoke 10 so as to facilitate connection between the terminal 22 and an external AC circuit.

The flexible circuit board 21 is designed to be two-section, and the first-section flexible circuit board 211 and the second-section flexible circuit board 212 are folded and wound to form two cylindrical stator windings 20. The electrical angles of the two turns of stator windings 20 differ by 120 degrees or 240 degrees, so that the stator windings 20 can generate a more uniform rotating magnetic field, so that the rotor 40 of the motor rotates more stably and reduces the vibration and noise of the motor.

It can be understood that the present application provides a method of changing the coil 214 and structural design of the flexible circuit board 21 to achieve windings with different phases and different forms. Therefore, the protection scope of the present application is not limited to the above technical solution of providing the flexible circuit board 21 into two sections, and providing three coils 214 in each section. In another embodiment, two or more coils 214 can be set in the first-section flexible circuit board 211 and the second-section flexible circuit board 212, and the electrical angle difference between the two stator windings 20 formed by folding the first-section flexible circuit board 211 and the second-section flexible circuit board 212 can also be other angles.

As shown in FIG. 10 to FIG. 12, in one embodiment of the present application, the flexible circuit board 21 includes a first-section flexible circuit board 211, a second-section flexible circuit board 212 and a third-section flexible circuit board 213. The first-section flexible circuit board 211 and the third-section flexible circuit board 213 are respectively connected to the same side or opposite sides of the second-section flexible circuit board 212. The first-section flexible circuit board 211, the second-section flexible circuit board 212 and the third-section flexible circuit board 213 are provided with the same quantity of coils 214. The second-section flexible circuit board 212 is folded toward the first-section flexible circuit board 211 to partially overlap the first-section flexible circuit board 211, and the third-section flexible circuit board 213 is folded toward the second-section flexible circuit board 212 to partially overlap the second-section flexible circuit board 212. The first-section flexible circuit board 211, the second-section flexible circuit board 212 and the third-section flexible circuit board 213 are wound to form three turns of stator winding 20 provided along the radial direction of the stator yoke 10 sequentially.

In an embodiment, two coils 214 are provided in the conductive layer 23 of the first-section flexible circuit board 211, the second-section flexible circuit board 212 and the third-section flexible circuit board 213. The electrical angle width of the two coils 214 of each section of the conductive layer 23 is 180 degrees, and the electrical angles of the three sections of the stator winding 20 differs by 120 degrees or 240 degrees.

As is shown in FIG. 10, the basic structure of a "double-folded" stator winding 20 formed by two turns of flexible printed circuit board (FPCB) in an unfolded state. The stator winding is three-phase and is a symmetrical concentrated winding with an electrical angle width of 180°. The flexible circuit board 21 includes the first-section flexible circuit board 211, the second-section flexible circuit board 212 and the third-section flexible circuit board 213. The three sections of the flexible circuit board 21 differ by an electrical angle width of 120° or 240° in the tangential direction, and the coils 214 between the first-section flexible circuit board 211, the second-section flexible circuit board 212 and the third-section flexible circuit board 213 are electrically connected. The winding of phase A is a coil 214 provided on the first-section flexible circuit board 211. The first-section flexible circuit board 211 is formed into a winding with an electrical angle width of 180° wound from the outside to the inside. After the coil 214 in the first conductive layer 23 of the winding of phase A is input with current through the terminal 22, it is electrically connected to the coil 214 in the second conductive layer 23 of the first-section flexible circuit board 211 through the conductive perforation 215.

The second conductive layer 23 provided in the first-section flexible circuit board 211 is wound from the inside to the outside with an electrical angle width of 180°, and then transferred to the coil 214 of the second-section flexible circuit board 212 on the same conductive layer 23 through the lead wire. After the second-section flexible circuit board 212 is formed into a winding with an electrical angle width of 180° wound from the outside to the inside, it is electrically connected to the coil 214 of the first conductive layer 23 of the second-section flexible circuit board 212 through the conductive perforation 215.

The winding of phase B and phase C are respectively provided on the second-section flexible circuit board 212 and the third-section flexible circuit board 213, and the winding method is the same as the winding of phase A.

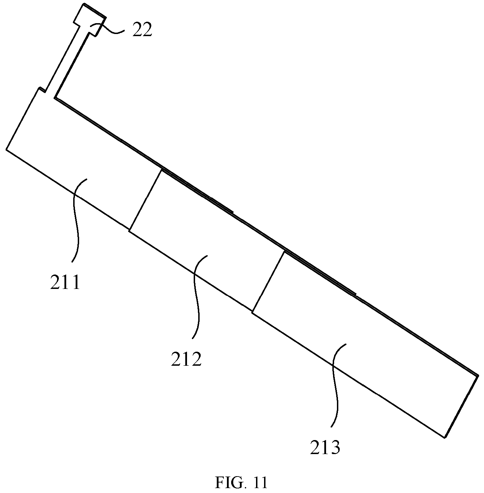

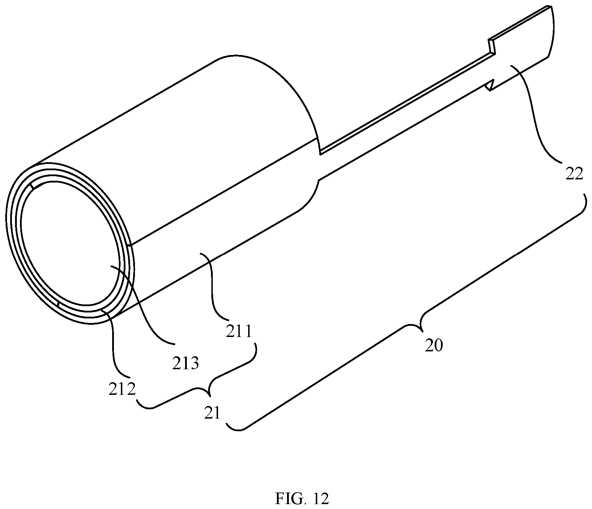

After the above-mentioned flexible circuit board 21 is rolled in the manner shown in FIG. 11 and FIG. 12, a cylindrical stator winding 20 is formed, and its outer diameter is the same as the inner diameter of the stator yoke 10. The cylindrical stator winding 20 is fixed to the inner side of the stator yoke 10 by gluing. The terminal 22 of the flexible circuit board 21 is extended to the outside of the stator yoke 10, so as to facilitate connection between the terminal 22 and an external AC circuit.

In the embodiment, the flexible circuit board 21 is designed to include a first-section flexible circuit board 211, a second-section flexible circuit board 212 and a third-section flexible circuit board 213. The second-section flexible circuit board 212 is folded toward the first-section flexible circuit board 211 to partially overlap the first-section flexible circuit board 211, and the third-section flexible circuit board 213 is folded toward the second-section flexible circuit board 212 to partially overlap the second-section flexible circuit board 212. The first-section flexible circuit board 211, the second-section flexible circuit board 212 and the third-section flexible circuit board 213 are respectively wound to form three turns of stator winding 20, and the electrical angle between each layer is 120° or 240°. This structure can make the rotating magnetic field generated by the stator winding 20 more stable and more uniform, so as to improve the stability of the rotation of the rotor 40 and the working efficiency of the motor, and reduce the vibration of the motor during operation.

The present application is not limited to the structural design, winding method of the flexible circuit board 21, and wiring design of the coils 214 in the motor stator proposed in the above embodiment. In other embodiments, the flexible circuit board 21 can also include a fourth-section flexible circuit board, and the quantity of coils 214 in each section is not limited to two or three. The stator winding 20 on the flexible circuit board 21 can be in the form of distributed, centralized or wave winding, and the three-phase system can be realized in a Y-type connection or a triangle connection. In addition, the winding can also be a single-phase, two-phase, or other multi-phase stator winding 20. All of the above belong to the protection scope of this application.

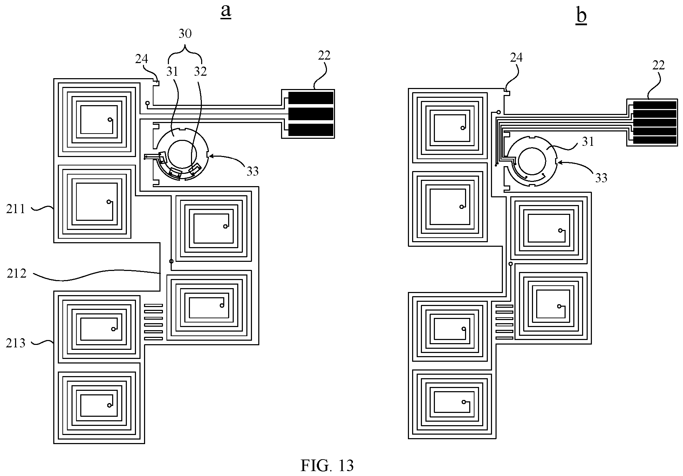

As shown in FIG. 1 and FIG. 13, in one embodiment of the present application, the motor stator further includes a magnetic field detection component 30, and the magnetic field detection component 30 includes a circuit control board 31 and a Hall sensor 32;

The Hall sensor 32 is provided on the circuit control board 31, and the circuit control board 31 is connected to the side of the flexible circuit board 21 provided with the terminal 22, and the flexible circuit board 21 is wound to form a cylindrical stator winding 20, and the circuit control board 31 is in the shape of a ring. After the flexible circuit board 21 is wound to form a cylindrical stator winding 20, the circuit control board 31 is then provided in a cover-like manner at the opening of the stator winding 20. A positioning groove is provided on the outer periphery of the circuit control board 31. A positioning tooth is provided at the opening of the stator winding 20. The positioning tooth is clamped in the positioning groove 33. The Hall sensor 32 is configured to detect the magnetic field of the rotor 40 when the motor is running, and then detect the electrical angle of the rotor 40.

In the embodiment, the circuit control board 31 is also flexible, so that the circuit control board 31 can be folded and covered at the opening of the stator winding 20. The circuit control board 31 is provided on a side of the flexible circuit board 21 close to the terminal 22, so that the circuit control board 31 is electrically connected to the external power source through the terminal 22. The Hall sensor 32 includes pins such as the positive pole of the power supply, the ground, the signal output, the control signal and the speed signal. Therefore, the Hall sensor 32 needs to be connected to a plurality of external connection lines. By designing the circuit control board 31 to be flexible, the circuit control board 31 and the flexible circuit board 21 can be integrated together during processing, so that the Hall sensor 32 can be electrically connected to the external circuit through the terminal 22, which greatly improves the space utilization of the motor, reduces the structural volume, and improves the convenience of wiring.

The quantity of the Hall sensors 32 can be multiple, which are arranged at intervals along the circumference of the circuit control board 31 to improve the detection accuracy of the magnetic field detection component 30 for the magnetic field at different positions of the rotor 40. A plurality of positioning grooves 33 are provided on the outer periphery of the annular circuit control board 31, and a plurality of positioning teeth 24 are protruded on one side of the flexible circuit board 21. The plurality of positioning teeth 24 and the circuit control board 31 are provided on the same side of the flexible circuit board 21. When the circuit control board 31 is covered at the opening of the stator winding 20, each positioning tooth 24 is engaged with with the positioning groove 33 of the circuit control board 31, so that the circuit control board 31 is accurately installed on the stator winding 20, thereby improving the accuracy and stability of the Hall sensor 32 in detecting the magnetic field of the rotor 40 when the motor is running.

The present application also provides an AC motor, including a front ring 50, a rear ring 60, a rotor 40, a bearing 70 and a motor stator. The specific structure of the motor stator is shown in the above embodiment. Since the AC motor adopts all the technical solutions of all the above embodiments of the motor stator, it at least has all the beneficial effects brought by the technical solutions of the above embodiments, which will not be repeated here.

The front ring 50 and the rear ring 60 are respectively provided at the two ends of the stator yoke 10, and are fixedly connected to the stator yoke 10 by bonding. The stator yoke 10 can be formed by splicing a plurality of annular silicon steel sheets 11. In order to strengthen the strength of the stator yoke 10, the annular silicon steel sheets 11 after bonding can also be welded together. The front ring 50 and the rear ring 60 are made of metal material or other hard material to improve the structural strength of the motor stator. When the front ring 50 and the rear ring 60 are made of metal, they can also be fixedly connected to the stator yoke 10 by welding.

The two bearings 70 of the motor are respectively mounted on the front ring 50 and the rear ring 60 of the motor. The magnetic steel of the motor is mounted on the rotating shaft of the rotor 40. One end of the rotor 40 is rotatably connected to the front ring 50 of the motor through the two bearings 70, and the other end of the rotor 40 is rotatably connected to the rear ring 60 of the motor through the two bearings 70. When the motor is working, the external controller inputs current into the three-phase winding of the motor through the terminal 22 of the flexible circuit board 21. Since the winding formed by the motor stator is symmetrically distributed in space, the three-phase time-domain symmetrical current will form a rotating magnetic field in the air gap of the motor, and interact with the magnetic field of the rotor 40 to drive the rotor 40 to rotate.

The above contents are only some embodiments of the present application, and do not limit the scope of the present application. All equivalent structural changes made by using the contents of the present application specification and drawings under the inventive concept of the present application, or directly/indirectly applied in other related technical fields are included in the scope of the present application.

## Claims

1. A motor stator, **characterized by** comprising:
a stator yoke; and
a stator winding;
wherein a cavity with two ends passing through is provided inside the stator yoke; the stator winding comprises a flexible circuit board formed by winding and having a same shape as the cavity; one end of the flexible circuit board is provided with a terminal, the terminal is configured to connect an external alternating current (AC) power source; the flexible circuit board comprises at least two conductive layers, and a plurality of groups of coils are provided in the conductive layers; the plurality of groups of coils are provided at intervals along a circumference of the stator yoke, and are electrically connected to the terminal; the at least two conductive layers are provided in a stacked manner with one on top of the other, and the plurality of groups of coils in the at least two conductive layers are stacked in pairs along the radial direction of the stator yoke, and magnetic field directions of two coils stacked on each other in the at least two conductive layers are the same; and
the flexible circuit board is attached to an inner wall of the stator yoke; current passes through the coil, generating a radial magnetic field perpendicular to the stator yoke in an air gap of the motor, and interacts with a rotor magnetic field to generate an electromagnetic torque required for an operation of the motor.

2. The motor stator of claim 1, wherein the at least two conductive layers are provided along a radial direction of the stator yoke sequentially, and a quantity of coils in the at least two conductive layers is the same.

3. The motor stator of claim 2, wherein the at least two conductive layers are provided with a conductive perforation in a middle of each coil; the conductive perforations of the at least two conductive layers are overlapped, and the conductive perforations are configured for establishing electrical connections between the coils of the at least two conductive layers.

4. The motor stator of claim 3, wherein three coils are provided in each conductive layer, and the flexible circuit board is wound along the circumference of the stator yoke to form a three-phase stator winding with an electrical angle width of 120 degrees.

5. The motor stator of any one of claims 1 to 4, wherein the flexible circuit board comprises a first-section flexible circuit board and a second-section flexible circuit board, and a quantity of coils provided in the first-section flexible circuit board and the second-section flexible circuit board is the same;
the second-section flexible circuit board is connected to one side of the first-section flexible circuit board and folded toward the first-section flexible circuit board, enabling the second-section flexible circuit board is provided above the first-section flexible circuit board and partially overlapped with the first-section flexible circuit board; and
the first-section flexible circuit board and the second-section flexible circuit board are wound to form two turns of stator windings provided along the radial direction of the stator yoke sequentially.

6. The motor stator of claim 5, wherein three coils are provided in a conductive layer of the first-section flexible circuit board and a conductive layer of the second-section flexible circuit board; an electrical angle width of the three coils in the conductive layer of the first-section flexible circuit board and the conductive layer of the second-section flexible circuit board is 120 degrees, and an electrical angle of two sections of the stator windings after winding differs by 120 degrees or 240 degrees.

7. The motor stator of any one of claims 1 to 4, wherein the flexible circuit board comprises a first-section flexible circuit board, a second-section flexible circuit board and a third section flexible circuit board, and the first-section flexible circuit board and the third-section flexible circuit board are respectively connected to a same side or opposite sides of the second-section flexible circuit board;
the first-section flexible circuit board, the second-section flexible circuit board and the third-section flexible circuit board are provided with a same quantity of coils; the second-section flexible circuit board is folded toward the first-section flexible circuit board to partially overlap the first-section flexible circuit board, and the third-section flexible circuit board is folded toward the second-section flexible circuit board to partially overlap the second-section flexible circuit board; and
the first-section flexible circuit board, the second-section flexible circuit board and the third-section flexible circuit board are wound to form three turns of stator winding provided along the radial direction of the stator yoke sequentially.

8. The motor stator of claim 7, wherein two coils are provided in a conductive layer of the first-section flexible circuit board, the second-section flexible circuit board and the third-section flexible circuit board; an electrical angle width of the two coils of each section of the conductive layer is 180 degrees, and electrical angles of three sections of the stator winding differ by 120 degrees or 240 degrees.

9. The motor stator of any one of claims 1 to 4, further comprising:
a magnetic field detection component;
wherein the magnetic field detection component comprises a circuit control board and a Hall sensor; the Hall sensor is provided on the circuit control board, and the circuit control board is connected to a side of the flexible circuit board provided with the terminal; the flexible circuit board is wound to form the stator winding, and the stator winding is cylindrical; the circuit control board is in a shape of a ring; after the flexible circuit board is wound to form the stator winding, the circuit control board is provided at an opening of the stator winding in a cover-like manner; an outer periphery of the circuit control board is provided with a positioning groove, and the opening of the stator winding is provided with a positioning tooth; the positioning tooth is clamped in the positioning groove; and the Hall sensor is configured to detect a magnetic field of a rotor when the motor is running, and then detect an angle of the rotor.

10. An AC motor, **characterized by** comprising:
a front ring;
a rear ring;
a rotor;
a bearing; and
the motor stator according to any one of claims 1 to 9.
